# EUROPEAN PATENT APPLICATION

(11) **EP 4 847 881 A1**
(43) Date of publication of application: **02.12.2026**
(21) Application number: 26178751.9
(22) Date of filing: 14.05.2026
(51) Int. Cl.: G01C 19/5733, B81B 3/00

(54) **MEMS-TYPE DEVICE WITH LINEAR MECHANICAL BEHAVIOUR AND IMPROVED MECHANICAL ROBUSTNESS**

(30) Priority: 30.05.2025 IT 202500012652
(71) Applicant: STMicroelectronics International N.V., 1228 Plan-les-Ouates, Geneva (CH)
(72) Inventor: CARULLI, Paola, 20864 AGRATE BRIANZA (MB) (IT); FALORNI, Luca Giuseppe, 20864 AGRATE BRIANZA (MB) (IT); FEDELI, Patrick, 20864 AGRATE BRIANZA (MB) (IT); MORELLI, Federico, 20864 AGRATE BRIANZA (MB) (IT)
(74) Representative: Studio Torta S.p.A.

(57) **Abstract**

Device (30) of the MEMS type, comprising: a frame body (32); an anchoring element (40) fixed to the frame body (32); a seismic mass (34) elastically coupled to the frame body (32); and an elastic group (36) between the anchoring element (40) and the seismic mass (34). The elastic group (36) comprises a first (42') and a second (42") internal portion, a first (44') and a second (44") external portion, external to the internal portions, and a connection portion (46) that joins the external portions and the internal portions, the internal portions being constrained to the anchoring element on the opposite side with respect to the connection portion and the external portions being constrained to the seismic mass on the opposite side with respect to the connection portion. The anchoring element (40) comprises a first (48) and a second (50) anchoring portion, joined to each other and fixed to the frame body (32), the internal portions being constrained to the first anchoring portion (48), the first anchoring portion (48) extending between the seismic mass (34) and the second anchoring portion (50), and the second anchoring portion (50) extending between the internal portions.

## Description

### TECHNICAL FIELD

The present invention relates to a MEMS-type device with linear mechanical behavior and improved mechanical robustness. Furthermore, it relates to a MEMS-type gyroscope comprising the device.

### BACKGROUND

As is known, inertial sensors, such as accelerometers and gyroscopes, and inertial actuators often require accurate control of the seismic mass movement to avoid malfunctions or inaccurate measurements.

In particular, it is often important that the seismic mass (e.g., the drive mass of a gyroscope) is free to oscillate only along its oscillation direction, i.e. that the elastic group that ensures the oscillation of the seismic mass has a high stiffness to the movements along the axes perpendicular to the oscillation direction.

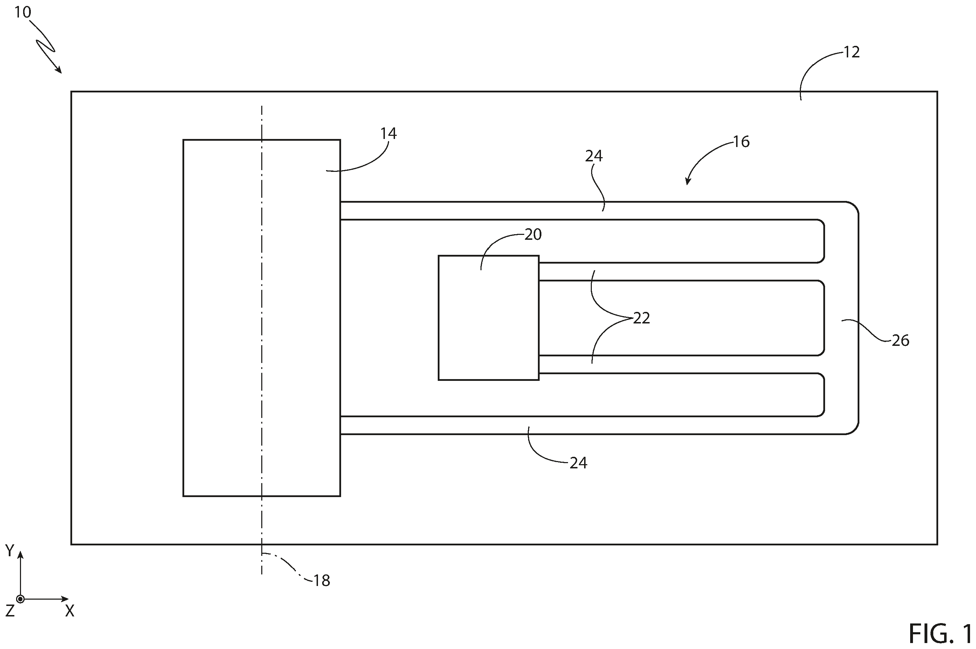

Several solutions are now known that allow avoiding these drawbacks. In particular, the structure of the elastic group of Figure 1 is known to have a very low stiffness to the movements along the oscillation direction of the seismic mass and a very high stiffness to the movements along the axes perpendicular to the oscillation direction.

In particular, Figure 1 shows a device 10 of the MEMS type, in particular comprised in an inertial sensor or actuator, that comprises a frame body 12, a seismic mass 14 and an elastic group 16 that elastically couples the seismic mass 14 to the frame body 12 allowing the oscillation of the seismic mass 14 with respect to the frame body 12 along an oscillation direction 18, here exemplarily parallel to the Y-axis.

The elastic group 16 is coupled to the frame body 12 through an anchoring element 20 fixed to the frame body 12.

In particular, the elastic group 16 comprises internal portions 22, external portions 24 and a connection portion 26. The internal portions 22 and the external portions 24 are of the elongated type along the direction of the X-axis, for example they have a strip shape, and extend in such a way as to be substantially parallel to each other. The connection portion 26 is of the elongated type along the direction of the Y-axis, for example it has a strip shape, and extends in such a way as to join the internal portions 22 and the external portions 24 to each other.

In detail, the internal portions 22 extend, along the direction of the Y-axis, internally to the external portions 24.

The internal portions 22 are constrained to the anchoring element 20 and, on the opposite side with respect to the anchoring element 20, are fixed to the connection portion 26.

The external portions 24 instead join the seismic mass 14 to the connection portion 26.

Consequently, the anchoring element 20 extends exclusively between the external portions 24 along the Y-axis. Furthermore, it extends between the seismic mass 14 and the internal portions 22 along the X-axis.

In use, the movement of the seismic mass 14 along the oscillation direction 18 is allowed by virtue of the elastic bending of the internal portions 22 and the external portions 24 along the direction of the Y-axis.

This structure of the elastic group 16 is known to effectively constrain the movement of the seismic mass 14 along the oscillation direction 18 even for high oscillation amplitudes of the seismic mass 14, while ensuring high stiffness along the direction of the X-axis.

However, this structure of the elastic group 16 introduces a non-linear behavior in the mechanical operation of the device 10, dependent on the mismatch between the length of the internal portions 22 and the length of the external portions 24 along the direction of the X-axis. In detail, the mechanical non-linearity increases as this mismatch increases.

To limit this non-linearity behavior, the same length is usually tried to be maintained between the internal portions 22 and the external portions 24, but at the expense of a lower mechanical robustness of the device 10 or a greater bulk of the elastic group 16, and therefore of the device 10.

In fact, a first solution to this issue consists in reducing the dimensions of the anchoring element 20 along the X-axis and in moving it as close as possible to the seismic mass 14, to reduce as much as possible the length mismatch of the internal portions 22 and the external portions 24.

However, having a reduced extension of the anchoring element 20 implies reducing the mechanical robustness of the device 10, due to the greater possibility that the anchoring element 20 detaches from the frame body 12 when the seismic mass 14 is subject to accelerations or actuations of significant entity.

A second solution to this issue consists in the use of a seismic mass 14 that, in top view, has a concavity facing the anchoring element 20 and the elastic group 16. In this case, the anchoring element 20 extends within this concavity of the seismic mass 14, so that the internal portions 22 and the external portions 24 have a length that is substantially equal to each other.

However, this complicates the design and manufacturing of the device 10 and increases the overall area consumption and therefore the cost of the device 10.

Document US 2025/020464 A1 is directed in general to the field of phase locked loop (PLL) semiconductor devices and, in particular, it relates to microelectromechanical systems (MEMS) gyroscope devices and methods for operating same to support PLL operational stability.

Therefore, none of the current solutions allows for an inertial device with high mechanical reliability, small dimensions and linear response at the same time.

### SUMMARY

The aim of the present invention is to provide a device and a gyroscope that overcome the drawbacks of the prior art.

According to the present invention, a device and a gyroscope are provided, as defined in the annexed claims that form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 is a schematic top view of a portion of a known-type inertial device;
- Figure 2 is a schematic top view of a portion of an inertial-type device, according to an embodiment of the present solution;
- Figure 3 is a schematic top view of a portion of an inertial-type device, according to a different embodiment of the present solution; and
- Figure 4 is a detailed plan view of a sense structure of a triaxial-type MEMS gyroscope that comprises the device of Figure 2, according to an embodiment of the present solution.

In the following description, elements common to the different embodiments have been indicated with the same reference numbers.

### DETAILED DESCRIPTION OF THE INVENTION

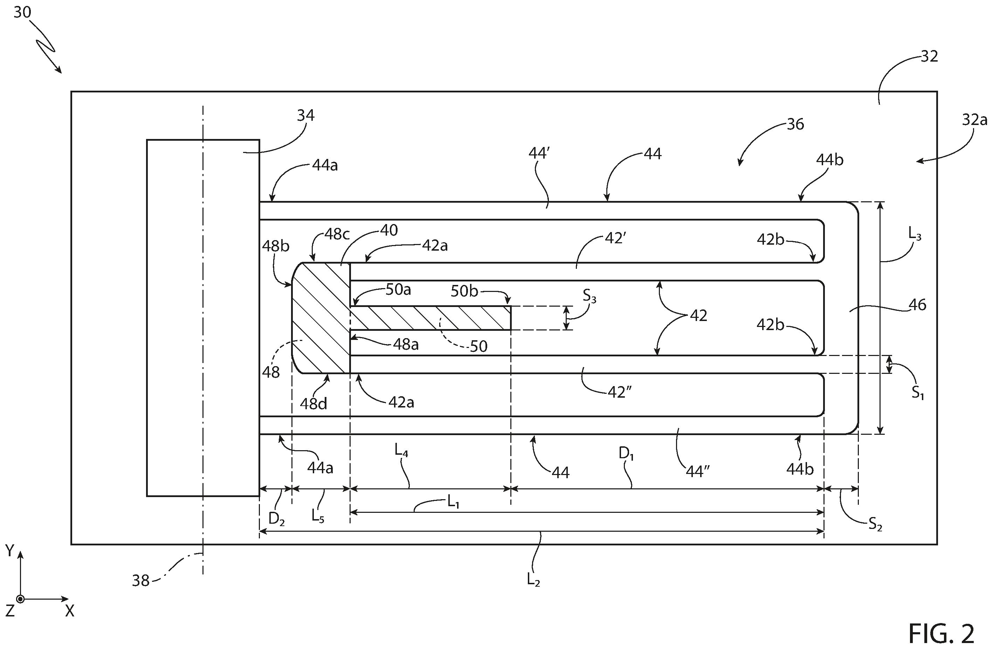

Figure 2 shows a device 30 of the MEMS-type, in particular comprised in an inertial actuator or an inertial sensor, such as a gyroscope or an accelerometer.

In particular, Figure 2 is shown with reference to a triaxial Cartesian system defined by an X-axis, a Y-axis and a Z-axis, orthogonal to each other.

In the following, reference is made exemplarily to the case in which the device 30 is comprised in an inertial sensor. However, other embodiments may similarly be considered.

In detail, Figure 2 shows, in top view, the device 30 in an XY plane defined by the axes X and Y.

In the following, it is considered exemplarily that the gravitational force acts along the Z-axis, that therefore defines a gravity axis or vertical axis of the device 30.

In Figure 2 only the elements useful for understanding the present embodiment are illustrated, and elements or components that, although present in the finished device, are not relevant to the present invention are not shown.

The device 30 is formed through micromachining techniques starting from a body of semiconductor material, for example silicon.

The device 30 comprises a semiconductor body (hereinafter also referred to as a frame body) 32 with an upper surface 32a and a lower surface (not shown), opposite to each other along the Z-axis.

The device 30 comprises a seismic mass 34 elastically coupled to the frame body 32, in such a way that in use the seismic mass 34 may move (in detail, oscillate elastically) with respect to the frame body 32, in particular along an oscillation direction 38.

The oscillation direction 38 is here exemplarily shown parallel to the Y-axis, nevertheless other arrangements may similarly be considered (e.g., the oscillation direction 38 may be parallel to the X-axis).

As shown in Figure 2, the seismic mass 34 extends above the frame body 32 along the Z-axis, at a distance therefrom. In other words, the upper wall 32a of the frame body 32 faces along the Z-axis towards the seismic mass 34.

The device 30 also comprises an elastic group 36, of the elastic type, that elastically couples the seismic mass 34 to the frame body 32, allowing in use the oscillation of the seismic mass 34 with respect to the frame body 32 along the oscillation direction 38.

The elastic group 36 is constrained, at its first end, to the frame body 32 through an anchoring element 40 fixed to the frame body 32. Furthermore, the elastic group 36 is constrained, at its second end, to the seismic mass 34.

In particular, the elastic group 36 comprises internal portions 42, in detail a first and a second internal portion (also referred to as first and second internal arms) 42' and 42", and external portions 44, in detail a first and a second external portion (also referred to as first and second external arms) 44' and 44", and a connection portion 46.

The internal portions 42 and the external portions 44 are of the elongated type along the direction of the X-axis (i.e. along a direction orthogonal to the oscillation direction 38 and parallel to the upper surface 32a), for example they have a strip shape.

The internal portions 42 and the external portions 44 extend in such a way as to be substantially parallel to each other, in case the seismic mass 34 is not subject to external accelerations and/or is not electrically driven as better described below (static mode of the device 30).

The connection portion 46 is of the elongated type along the direction of the Y-axis (i.e. along a direction parallel to the oscillation direction 38), for example it has a strip shape.

The connection portion 46 extends in such a way as to join the internal portions 42 and the external portions 44 to each other.

In detail, the internal portions 42 extend, along the direction of the Y-axis, internally to the external portions 44.

Each of the internal portions 42 has a respective first end 42a and a respective second end 42b, opposite to each other along its main extension direction parallel to the X-axis. Furthermore, each of the external portions 44 has a respective first end 44a and a respective second end 44b, opposite to each other along its main extension direction parallel to the X-axis.

The internal portions 42 elastically couple the anchoring element 40 to the connection portion 46.

In detail, the internal portions 42 are constrained to the anchoring element 40 at their first ends 42a and are fixed to the connection portion 46 at their second ends 42b.

The external portions 44 instead elastically couple the seismic mass 34 to the connection portion 46.

In detail, the external portions 44 are constrained to the seismic mass 34 at their first ends 44a and are fixed to the connection portion 46 at their second ends 44b.

In particular, the second ends 42b and 44b of the internal portions 42 and the external portions 44 extend starting from a same lateral surface of the connection portion 46, that is arranged facing the seismic mass 34 along the direction of the X-axis.

As is evident, the first ends 42a of the internal portions 42 define the first end of the elastic group 36, while the first ends 44a of the external portions 44 define the second end of the elastic group 36.

The internal portions 42 and the external portions 44 are flexible, i.e. they are elastically deformable along the direction of the Y-axis (without there being substantially a deformation of their cross-sections).

Furthermore, the internal portions 42 and the external portions 44 are substantially rigid both to torsional moments and contractions/elongations along the main extension direction.

Instead, the connection portion 46 is substantially rigid to torsions, bendings and deformations of its cross-section.

By virtue of the structure and mechanical properties of the elastic group 36, in use the movement of the seismic mass 34 along the oscillation direction 38 is allowed by virtue of the elastic bending of the internal portions 42 and the external portions 44.

In particular, this occurs when the seismic mass 34 is subject to external accelerations along the oscillation direction 38 and/or is electrically driven as better described below (dynamic mode of the device 30).

As shown in Figure 2, the internal portions 42 each have a length L₁ along the direction of the X-axis (e.g., measured between the ends 42a and 42b) and the external portions 44 each have a length L₂ along the direction of the X-axis (e.g., measured between the ends 44a and 44b).

According to one embodiment, a ratio L₁/L₂ between the length L₁ and the length L₂ is comprised between about 75% and about 98% and is, for example, equal to about 85-90%.

For example, the length L₁ is comprised between about 60 µm and about 260 µm and is, for example, equal to about 140 µm, and the length L₂ is comprised between about 80 µm and about 270 µm and is, for example, equal to about 160 µm.

Furthermore, the internal and external portions 42 and 44 each have a width S₁ along the direction of the Y-axis that, for illustrative and non-limiting purposes, may be comprised between about 2 µm and about 9 µm and may be, for example, equal to about 4 µm.

The connection portion 46 has a width S₂ along the direction of the X-axis that, for illustrative and non-limiting purposes, may be comprised between about 7 µm and about 20 µm and may be, for example, equal to about 10 µm.

Furthermore, the connection portion 46 has a length L₃ along the direction of the Y-axis that, for illustrative and non-limiting purposes, may be comprised between about 30 µm and about 150 µm and may be, for example, equal to about 60 µm.

Again with reference to Figure 2, the anchoring element 40 is fixed to the frame body 32 and extends along the Z-axis starting from the upper surface 32a of the frame body 32.

The anchoring element 40 comprises a first anchoring portion 48 and a second anchoring portion 50, joined with continuity to each other in such a way as to make the anchoring element 40 monolithic.

Along the direction of the X-axis, the first anchoring portion 48 extends between the seismic mass 34 and the second anchoring portion 50, at a distance from the seismic mass 34.

Furthermore, along the direction of the X-axis, the second anchoring portion 50 extends between the first anchoring portion 48 and the connection portion 46, at a distance from the latter.

The first anchoring portion 48 extends along the direction of the Y-axis between the first and second external portions 44' and 44", at a distance from the latter, while the second anchoring portion 50 extends along the direction of the Y-axis between the first and second internal portions 42' and 42", at a distance from the latter and in particular in such a way as to be equidistant from the latter along the direction of the Y-axis.

In detail, the first anchoring portion 48 is arranged laterally to the internal portions 42' and 42" along the direction of the X-axis, therefore the first anchoring portion 48 does not extend along the direction of the Y-axis between the first and second internal portions 42' and 42".

The first ends 42a of the internal portions 42 are fixed to the first anchoring portion 48, in particular on the opposite side of the latter with respect to the seismic mass 34.

In detail, the first anchoring portion 48 has at least a first and a fourth surface 48a-48d, where the first and second surfaces 48a and 48b are opposite to each other along the X-axis and face respectively the connection portion 46 and the seismic mass 34 and where the third and fourth surfaces 48c and 48d are opposite to each other along the Y-axis and face respectively the first and second external portions 44' and 44".

The second anchoring portion 50 extends starting from the first surface 48a of the first anchoring portion 48 towards the connection portion 46, without reaching the latter.

Consequently, the first anchoring portion 48 extends between the external portions 44 along the Y-axis and between the seismic mass 34 and the internal portions 42 along the X-axis, while the second anchoring portion 50 extends between the internal portions 42 along the Y-axis and between the first anchoring portion 48 and the connection portion 46 along the X-axis.

In the embodiment exemplarily shown in Figure 2, the first anchoring portion 48 has an elongated shape along the direction of the Y-axis, for example, it has a substantially rectangular shape in top view, with a main extension along the Y-axis.

Nevertheless, other shapes may similarly be considered for the first anchoring portion 48 (e.g., rhomboid shape, square shape, etc.).

In the embodiment exemplarily shown in Figure 2, the second anchoring portion 50 has an elongated shape along the direction of the X-axis, for example, it has a substantially rectangular shape in top view, with a main extension along the X-axis.

Nevertheless, other shapes may similarly be considered for the second anchoring portion 50, as better described below.

As shown in Figure 2, the second anchoring portion 50 has a length L₄ along the direction of the X-axis (e.g., a maximum length). In particular, the second anchoring portion 50 has a first end 50a, joined to the first anchoring portion 48 at the first surface 48a, and a second end 50b, opposite to the first end 50a along the direction of the X-axis and facing the connection portion 46; the length L₄ is here measured between the first and second ends 50a, 50b.

According to one embodiment, a ratio L₄/L₁ between the length L₄ and the length L₁ is comprised between about 15% and about 70% and is for example equal to about 40%.

For example, the length L₄ is comprised between about 15 µm and about 130 µm and is for example equal to about 50 µm.

Based on the values provided so far, the value of a distance D₁ (in detail, a minimum distance) between the second end 50b of the second anchoring portion 50 and the connection portion 46 may thus be obtained as a result, in a per se evident manner.

In the example of Figure 2, the second anchoring portion 50 has a width S₃ along the direction of the Y-axis that, for illustrative and non-limiting purposes, may be greater than about 8 µm and may be, for example, equal to about 12 µm.

In particular, in the example of Figure 2, the width S₃ is substantially constant throughout the extension of the second anchoring portion 50 (i.e. the second anchoring portion 50 has a uniform and constant width).

Furthermore, the first anchoring portion 48 has a distance D₂ from the seismic mass 34 (in detail, a minimum distance), along the direction of the X-axis, and a length L₅ along the direction of the X-axis (e.g., a maximum length) .

According to one embodiment, a ratio D₂/L₅ between the distance D₂ and the length L₅ is comprised between about 3% and about 20% and is for example equal to about 10%.

For example, the length L₅ is comprised between about 10 µm and about 25 µm and is for example equal to about 20 µm.

It has been verified that the use of the anchoring element 40 with the first and second anchoring portions 48, 50 respectively allows to reduce the dimensions of the first anchoring portion 48 with respect to the currently known solutions (thus reducing the gap between the lengths L₁ and L₂ and therefore allowing to ensure a linear mechanical behavior of the elastic group 36), while maintaining a high anchoring mechanical robustness by virtue of the additional contribution of the second anchoring portion 50.

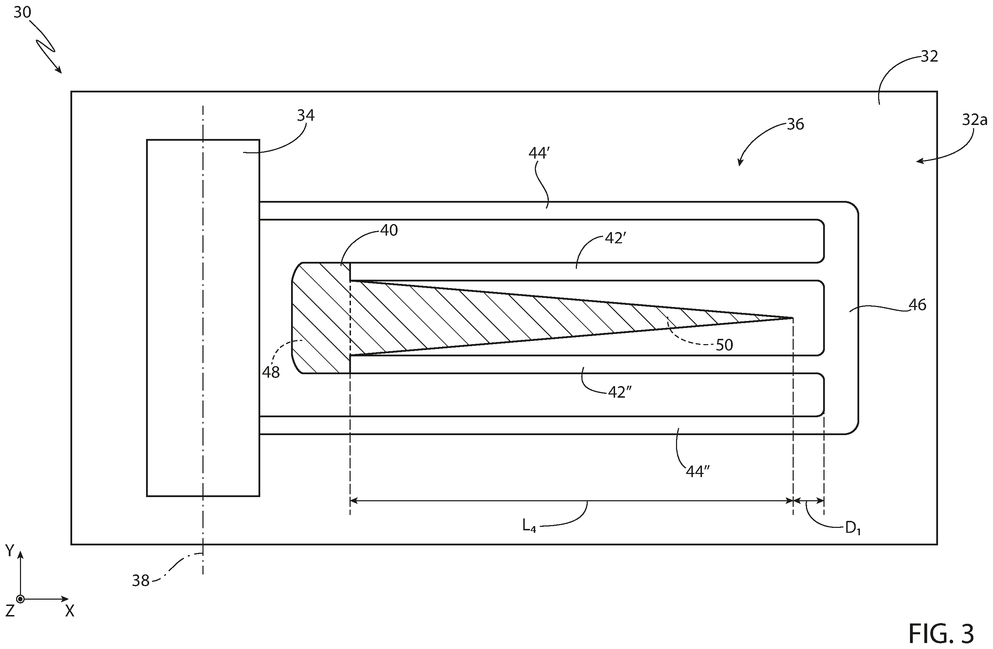

Figure 3 shows the device 30 in a different embodiment, in the same triaxial Cartesian system defined by the axes X, Y and Z.

In particular, in Figure 3 the second anchoring portion 50 is tapered going from the first end 50a towards the second end 50b, that is, it has the width S₃ that decreases going from the first end 50a towards the second end 50b.

For example, the width S₃ that decreases with continuity going from the first end 50a towards the second end 50b.

For illustrative and non-limiting purposes, the second anchoring portion 50 has a triangular shape in top view, with the base (and therefore the maximum width S₃) at the first end 50a and the vertex (and therefore the minimum width S₃, ideally substantially zero) at the second end 50b.

Nevertheless, other shapes of the second anchoring portion 50 may be similarly considered, for example a trapezoidal shape with major base (and therefore the maximum width S₃) at the first end 50a and minor base (and therefore the minimum width S₃) at the second end 50b.

This tapered shape of the second anchoring portion 50 allows to maximize the ratio L₄/L₁ and minimize the ratio D₁/L₁, thus further increasing the mechanical robustness of the device 30, without however risking that the internal portions 42 abut against the second anchoring portion 50 when the seismic mass 34 is subject to high accelerations or high electrical drive values that cause wide oscillations of the connection portion 46.

In general, the shape of the second anchoring portion 50, the ratio L₄/L₁ and the distance along the direction of the Y-axis between the second anchoring portion 50 and the internal portions 42 are determined in the design step as a function of the full scale of the device 30 (i.e. the maximum allowed oscillation of the seismic mass 34 along the oscillation direction 38 before hitting the stoppers, not shown), in such a way as to avoid in use direct contact between the second anchoring portion 50 and the internal portions 42.

As previously described, the device 30 may be comprised in an inertial sensor or an inertial actuator.

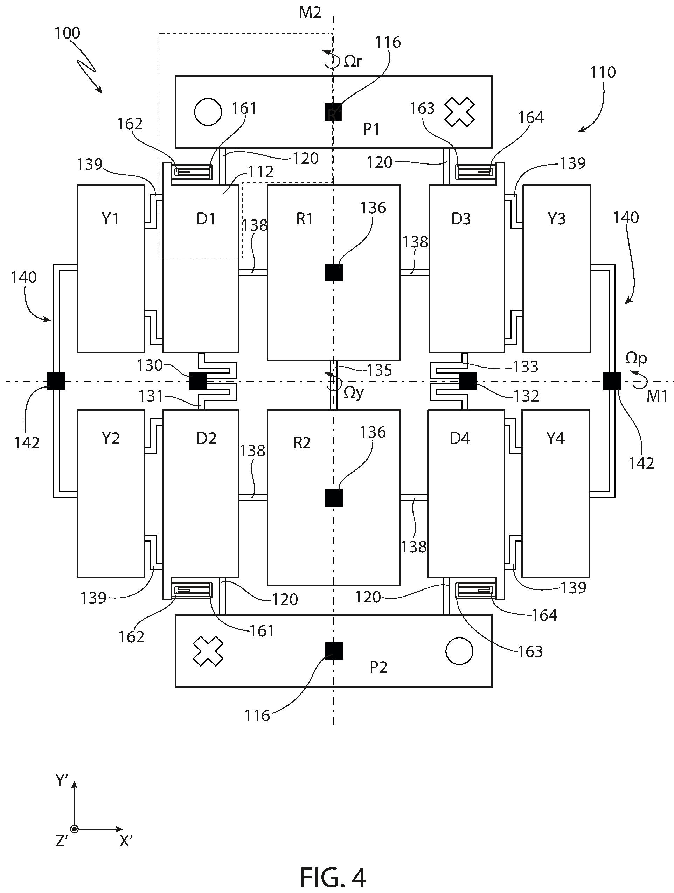

With reference to Figure 4, an exemplary embodiment of application of the device 30 is now described, wherein the latter is comprised in a MEMS-type gyroscope. Nonetheless, other applications may similarly be considered (e.g., uniaxial, biaxial or triaxial accelerometer, or other MEMS gyroscope structures), although not described in detail herein.

The general structure of the gyroscope, described herein and shown in Figure 4, is similar to that disclosed in patent document EP4718026 of the same Applicant, except for the specific use of the elastic group 36 and the anchoring element 40 previously described.

Consequently, the structure, operation, manufacturing and possible applications are entirely similar to what is described in patent document EP4718026.

In Figure 4, the gyroscope is indicated with the reference 100.

In detail, Figure 4 is shown with reference to a triaxial Cartesian system defined by an X' axis, a Y' axis and a Z' axis, orthogonal to each other.

The gyroscope 100, in particular of the triaxial type, has a microelectromechanical structure 110 with a main extension in a horizontal plane X'Y' defined by the axes X' and Y' (in a manner not illustrated, being suspended above a substrate, at a certain separation distance along the vertical axis Z').

The ensemble of the substrate, the microelectromechanical structure 110 and optionally other components, not described here because they are of a known type and not useful for understanding the present invention, defines the gyroscope 100. The substrate is not shown here for simplicity and corresponds to the frame body 32 previously described.

The microelectromechanical structure 110 also has a first and a second symmetry axis (or median axis) M1, M2, directed respectively along the horizontal axis X' and along the horizontal axis Y'.

The microelectromechanical structure 110 comprises a first drive mass D1 and a second drive mass D2, that form a first pair of drive masses D1, D2, arranged on a same side of the second axis of symmetry M2, aligned along the horizontal axis Y'.

Each of the drive masses of the first pair D1,D2 is elastically coupled to the substrate thorough a respective first anchoring elastic element 161 that is constrained to a respective first drive anchor 162, integral with the substrate (in a manner not illustrated).

Each drive mass D1, D2 is defined by a respective seismic mass 34 previously described, each first anchoring elastic element 161 is defined by a respective elastic group 36 previously described, and each first drive anchor 162 is defined by a respective anchoring element 40 previously described. For example, the shape of the anchoring element 40 of Figure 2 is considered here, although other shapes might similarly be considered (e.g., that of Figure 3).

The drive masses of the first pair D1,D2 are also coupled to a same second drive anchor 130, integral with the substrate (in a manner not illustrated), arranged centrally at the first axis of symmetry M1, by a respective second anchoring elastic element 131, of the folded or bellows type.

The microelectromechanical structure 110 also comprises a third and a fourth drive mass, indicated by D3 and D4, that form a second pair of drive masses.

The drive masses of the second pair D3,D4 are arranged on a second side of the second axis of symmetry M2, aligned along the horizontal axis Y', in a manner symmetrical to the drive masses of the first pair D1,D2 with respect to the same second axis of symmetry M2.

Each of the drive masses of the second pair D3,D4 is elastically coupled to the substrate through a respective third anchoring elastic element 163 that is constrained to a respective third drive anchor 164, integral with the substrate (in a manner not illustrated).

Each drive mass D3, D4 is defined by a respective seismic mass 34 previously described, each third anchoring elastic element 163 is defined by a respective elastic group 36 previously described, and each third drive anchor 164 is defined by a respective anchoring element 40 previously described. For example, the shape of the anchoring element 40 of Figure 2 is considered here, although other shapes might similarly be considered (e.g., that of Figure 3).

The drive masses of the second pair D3,D4 are in this case coupled to a same fourth drive anchor 132, integral with the substrate (in a manner not illustrated), arranged centrally at the first axis of symmetry M1, by a respective fourth anchoring elastic element 133, of the folded or bellows type (again in a manner completely symmetrical with respect to the drive masses of the first pair D1, D2).

For example, along the direction of the horizontal axis Y' the anchoring elastic elements 161, 163 and the drive anchors (also referred to as drive spring anchors) 162, 164 extend on the opposite side of the respective drive masses D1-D4 with respect to the respective anchoring elastic elements 131, 133, that is, they extend externally to the respective drive masses D1-D4 while the anchoring elastic elements 131, 133 extend between the respective drive masses D1-D4 of the first and second pair of drive masses.

In a manner not illustrated in detail here, the drive masses of the first and second pair D1,D2, D3,D4 may define therewithin windows for movable drive electrodes, integral with the same masses and interdigitated with corresponding fixed drive electrodes, also arranged within the same windows; in a manner known per se, the interaction between the interdigitated electrodes determines the aforementioned drive movement.

The microelectromechanical structure 110 of the MEMS gyroscope further comprises a first pitch sense mass P1 and a second pitch sense mass P2, used for sensing a pitch angular velocity, and that form a pair of pitch sense masses P1,P2.

Each sense mass P1, P2 has a respective sense anchoring element 116 arranged centrally with respect to the sense mass P1, P2, that is connected to said sense anchoring element 116 by a respective elastic arrangement (not shown).

In particular, the pitch sense masses P1,P2 are arranged in a symmetrical manner with respect to the first axis of symmetry M1, externally with respect to the drive masses D1,D2, D3,D4 (along the direction of the horizontal axis Y') and extend in length along the horizontal axis X' traversing the second axis of symmetry M2, symmetrically with respect to the same second axis of symmetry M2.

The first pitch sense mass P1 is elastically coupled to both the first drive mass D1 and the third drive mass D3 (i.e. to the drive masses arranged on a same side with respect to the first axis of symmetry M1) through a respective coupling elastic element 120, configured and operating in a manner completely similar to what has been previously described.

Similarly, the second pitch sense mass P2 is elastically coupled to both the second drive mass D2 and the fourth drive mass D4 through a respective coupling elastic element 120, again configured and operating in a manner entirely similar to what has been previously described.

Consequently, along the direction of the horizontal axis Y' the anchoring elastic elements 161, 163 and the drive anchors 162, 164 extend between the respective drive masses D1-D4 and the respective pitch sense masses P1, P2, laterally to the coupling elastic elements 120 along the direction of the horizontal axis X'.

The microelectromechanical structure 110 also comprises a first and a second roll sense mass R1, R2, arranged symmetrically to each other on opposite sides of the first axis of symmetry M1 and elastically connected to each other by a coupling elastic element 135, arranged centrally at the second axis of symmetry M2 and having a stiffness such as to allow the motion of the roll sense masses R1, R2 (as will be described in detail below) and, at the same time, such as to keep them constrained to each other in their movement.

The roll sense masses R1, R2 are generally arranged in a central position internally to the drive masses of the first and second pair D1,D2, D3,D4.

Each roll sense mass R1, R2 has a substantially rectangular shape in the horizontal plane X'Y', in the example elongated along the horizontal axis Y' and has centrally a window (not illustrated here for reasons of illustrative simplicity) within which a respective roll anchor 136 is arranged, to which it is coupled by an elastic coupling arrangement (not shown for simplicity of illustration) that defines a rotation axis thereof (directed in the example along the horizontal axis X') for the sense movement outside the horizontal plane X'Y'.

This elastic coupling arrangement may for example be provided as described in detail in the patent application EP4686911 of the same Applicant.

Furthermore, the first roll sense mass R1 is elastically coupled to the first and third drive masses D1, D3, by a respective elastic coupling elements 138, that extend starting from opposite sides of the same first roll sense mass R1, aligned along the horizontal axis X'. Such elastic coupling elements 138 may for example be of a linear type.

Similarly, the second roll sense mass R2 is elastically coupled to the second and fourth drive masses D2, D4, by respective elastic coupling elements 138, that extend starting from opposite sides of the same second roll sense mass R2 generally along the horizontal axis X' (being for example of a linear type).

Respective fixed or stator electrodes, capacitively coupled to the respective roll sense masses R1,R2 and positioned above the substrate (to provide a differential sense pattern, of a type known per se, not described in detail here) are arranged (in a manner not illustrated here) below the roll sense masses R1,R2. A completely similar argument also applies to the pitch sense masses P1,P2, previously described.

The microelectromechanical structure 110 of the MEMS gyroscope also comprises a first pair of yaw sense masses Y1,Y2 and a second pair of yaw sense masses Y3, Y4, each having a substantially rectangular shape in the horizontal plane, in the example elongated along the horizontal axis Y' .

Each yaw sense mass of the first pair Y1,Y2 is elastically coupled to a respective drive mass of the first pair of drive masses D1,D2 by respective coupling elastic elements 139 (in the example, in a number equal to two for each mass, interposed between end portions of the coupled drive and yaw sense masses).

Similarly, each yaw sense mass of the second pair Y3,Y4 is elastically coupled to a respective drive mass of the second pair of drive masses D3,D4 by respective coupling elastic elements 139.

Furthermore, the yaw sense masses of the first pair Y1,Y2, and the yaw sense masses of the second pair Y3,Y4, are respectively coupled to each other by respective elastic coupling structures 140, that extend centrally along the horizontal axis Y', traversing the first axis of symmetry M1.

In detail, each elastic coupling structure 140 defines a lever elastic element, of the central fulcrum type, hinged to the substrate by a central anchor 142 and coupled at its ends to the respective yaw sense masses that form the first or second pair.

In a manner not illustrated for reasons of simplicity of representation, the yaw sense masses Y1,Y2, Y3, Y4 have internally windows for yaw movable sensing electrodes, integral with the same masses and alternating with corresponding yaw fixed or stator sensing electrodes, to define a differential sense pattern.

In use, each sense mass P1, P2 is configured to perform a rotation movement in the horizontal plane X'Y' around the respective sense anchoring element 116, dragged by the respective drive mass D1-D4, and a sense movement (i.e. a rotation movement outside the horizontal plane X'Y') around a rotation axis defined by the respective elastic arrangement, in response to an angular velocity around the horizontal axis X'. In detail, the rotation axis is directed along the horizontal axis Y', parallel to the translation drive movement of the respective drive mass D1-D4.

Nevertheless, the gyroscope may still be based on structures other than that of Figure 4.

For example, and in a manner not described in detail here, the general structure of the gyroscope may be similar to that disclosed in patent document EP4471375 of the same Applicant, except for the specific use of the elastic group 36 and the anchoring element 40 previously described.

In particular, in this case each of the drive masses (indicated in EP4471375 with the references D1, D2, D1', D2' and each corresponding to a respective seismic mass 34 previously described) may be elastically coupled to the substrate (indicated in EP4471375 with the reference 11 and corresponding to the frame body 32 previously described) through a respective elastic coupling element (indicated in EP4471375 with the reference 20 and corresponding to the elastic group 36 previously described) that is constrained to the substrate by a respective drive anchor (indicated in EP4471375 with the reference 19 and corresponding to the anchoring element 40 previously described).

Consequently, the structure, operation, manufacturing and possible applications are entirely similar to what is described in patent document EP4471375 and are therefore not repeated here for simplicity of description. For further details reference may still be made to this document.

However, it becomes apparent that other known structures of MEMS gyroscopes may similarly be considered in lieu of those described here (e.g., a structure with a single pair of drive masses), as well as other possible applications of the device 30 (e.g., as an accelerometer or as an inertial actuator).

From an examination of the characteristics of the invention made according to the present invention, the advantages that it affords are evident.

In particular, the device 30 allows to have a substantially linear mechanical behavior (i.e. for example with a non-linearity coefficient lower than about 0.05 µN/µm³) and at the same time an increase in mechanical robustness and a reduction in the space required and in the dimensions, cost and complexity of design and manufacturing.

Furthermore, the structure of the device 30 has a substantially zero or in any case negligible impact on the vibration modes of the device 30, in terms of frequencies and motion.

Finally, it is clear that modifications and variations may be made to the invention described and illustrated herein without thereby departing from the scope of the present invention, as defined in the attached claims.

For example, the different embodiments described may be combined with each other to provide further solutions.

Furthermore, the device 30 of Figures 2 and 3 may be symmetrical with respect to an axis of symmetry that coincides with the oscillation direction 38, for example by having a pair of elastic groups 36 and a pair of anchoring elements 40, arranged symmetrically to each other on sides of the seismic mass 34 that are opposite to each other along the direction of the X-axis.

## Claims

1. A device (30) of the MEMS type, comprising:
- a frame body (32);
- an anchoring element (40) fixed to the frame body (32);
- a seismic mass (34) elastically coupled to the frame body (32) and configured to move along an oscillation direction (38) with respect to the frame body (32), the oscillation direction (38) being parallel to a first axis (Y) and orthogonal to a second axis (X); and
- an elastic group (36) extending between the anchoring element (40) and the seismic mass (34) and configured to elastically couple the seismic mass (34) to the frame body (32),
wherein the elastic group (36) comprises a first (42') and a second (42") internal portion, a first (44') and a second (44") external portion and a connection portion (46), the first (42') and second (42") internal portions and the first (44') and second (44") external portions being of the type elongated parallel to the second axis (X) and the connection portion (46) being of the type elongated parallel to the first axis (Y), the first (42') and second (42") internal portion extending between the first (44') and second (44") external portion along the first axis (Y), the connection portion (46) joining to each other the first (42') and second (42") internal portions and the first (44') and second (44") external portions, the first (42') and second (42") internal portions being constrained to the anchoring element (40) on the opposite side with respect to the connection portion (46) and the first (44') and second (44") external portions being constrained to the seismic mass (34) on the opposite side with respect to the connection portion (46),
**characterized in that** the anchoring element (40) comprises a first (48) and a second (50) anchoring portion, joined to each other and fixed to the frame body (32),
wherein the first (42') and second (42") internal portions are constrained to the first anchoring portion (48),
wherein, parallel to the second axis (X), the first anchoring portion (48) extends between the seismic mass (34) and the second anchoring portion (50), and
wherein, parallel to the first axis (Y), the second anchoring portion (50) extends between the first (42') and the second (42") internal portions.

2. The device according to claim 1, wherein the frame body (32) has an upper surface (32a), the elastic group (36) and the seismic mass (34) facing the upper surface (32a) and at a distance from the upper surface (32a) parallel to a third axis (Z) orthogonal to the first (Y) and second (X) axes, the anchoring element (40) extending along the third axis (Z) starting from the upper surface (32a),
wherein each of the first (42') and second (42") internal portions has a respective first end (42a), fixed to the first anchoring portion (48), and a respective second end (42b), opposite to the first end (42a) parallel to the second axis (X) and fixed to the connection portion (46), and
wherein each of the first (44') and second (44") external portions has a respective first end (44a), fixed to the seismic mass (34), and a respective second end (44b), opposite to the first end (44a) parallel to the second axis (X) and fixed to the connection portion (46).

3. The device according to claim 1 or 2, wherein the first anchoring portion (48) has a first (48a) and a second (48b) surface opposite to each other parallel to the second axis (X),
wherein the second surface (48b) faces the seismic mass (34) and is at a distance from the seismic mass (34), and
wherein the second anchoring portion (50) extends starting from the first surface (48a) towards the connection portion (46) in such a way as to be at a distance from the connection portion (46).

4. The device according to anyone of the preceding claims, wherein the second anchoring portion (50) has an elongated shape parallel to the second axis (X) and is equidistant from the first (42') and second (42") internal portions parallel to the first axis (Y).

5. The device according to claim 4, wherein the second anchoring portion (50) has a tapered shape going from the first anchoring portion (48) towards the connection portion (46).

6. The device according to anyone of the preceding claims, wherein, parallel to the second axis (X), the first (42') and second (42") internal portions have a first length (L₁) and the first (44') and second (44") external portions have a second length (L₂),
wherein a first ratio (L₁/L₂) between the first length (L₁) and the second length (L₂) is comprised between 75% and 98%.

7. The device according to claim 6, wherein, parallel to the second axis (X), the second anchoring portion (50) has a third length (L₄),
wherein a second ratio (L₄/L₁) between the third length (L₄) and the first length (L₁) is comprised between 15% and 70%.

8. The device according to anyone of the preceding claims, wherein, parallel to the second axis (X), the first anchoring portion (48) has a minimum distance (D₂) from the seismic mass (34),
wherein, parallel to the second axis (X), the first anchoring portion (48) has a fourth length (L₅),
wherein a third ratio (D₂/L₅) between the minimum distance (D₂) and the fourth length (L₅) is comprised between 3% and 20%.

9. A gyroscope (100) of the MEMS type, comprising a device (30) according to anyone of the preceding claims.

10. The gyroscope according to claim 9, wherein the seismic mass (34) is defined by at least one drive mass (D1; D2; D1'; D2') of the gyroscope (100).

11. The gyroscope according to claim 10, of a triaxial type and comprising a substrate defining said frame body (32),
the gyroscope (100) further comprising a sense structure (110) suspended above the substrate,
wherein the sense structure (110) has a main extension in a horizontal plane (X'Y'), formed by a first (X') and a second (Y') horizontal axis, and is provided with: at least said first drive mass (D1) configured to perform a translation drive movement along the second horizontal axis (Y') of the horizontal plane (X'Y'); and at least a first pitch sense mass (P1) and a sense anchoring element (116) arranged centrally with respect to the same first pitch sense mass (P1) and connected to said first pitch sense mass (P1) by an elastic arrangement,
wherein said first pitch sense mass (P1) is coupled to the first drive mass (D1) by an elastic coupling element (120) and is configured to perform a rotation movement in said horizontal plane (X'Y') around the sense anchoring element (116), dragged by said first drive mass (D1), and a sense rotation movement outside said horizontal plane (X'Y') around a rotation axis defined by said elastic arrangement, in response to a first angular velocity around the first horizontal axis (X'),
wherein said rotation axis is directed along said second horizontal axis (Y'), parallel to said translation drive movement of the first drive mass (D1), and
wherein the first drive mass (D1) is elastically coupled to the substrate through a respective first anchoring elastic element (161) that is constrained to a respective first drive anchor (162) integral with the substrate, the first anchoring elastic element (161) defining said elastic group (36) and the first drive anchor (162) defining said anchoring element (40).

12. The gyroscope according to claim 11, wherein the microelectromechanical structure (10) has a first and a second axes of symmetry (M1, M2), directed respectively along the first horizontal axis (X') and along the second horizontal axis (Y') and comprises:
in addition to said first drive mass (D1), a second drive mass (D2), to form a first pair of drive masses, arranged on a same side of the second axis of symmetry (M2), aligned along the second horizontal axis (Y'); and also a third and a fourth drive mass, (D3, D4), that form a second pair of drive masses, arranged in a manner symmetrical to the drive masses of the first pair (D1,D2) with respect to the second axis of symmetry (M2) and aligned along the second horizontal axis (Y');
in addition to said first pitch sense mass (P1), a second pitch sense mass (P2), for sensing a pitch angular velocity around the first horizontal axis (X') and for forming a pair of pitch sense masses, arranged in a symmetrical manner with respect to the first axis of symmetry (M1), externally with respect to the drive masses of the first pair (D1,D2) and the second pair (D3,D4); wherein said first pitch sense mass (P1) is also elastically coupled to the third drive mass (D3) through a respective coupling elastic element (120), and said second pitch sense mass (P2) is elastically coupled to both the second drive mass (D2) and the fourth drive mass (D4) through respective coupling elastic elements (120);
a first and a second roll sense mass (R1, R2) for sensing a roll angular velocity around the second horizontal axis (Y'), arranged symmetrically to each other on opposite sides of the first axis of symmetry (M1) and elastically connected to each other by a coupling elastic element (135), arranged centrally at the second axis of symmetry (M2), said roll sense masses (R1, R2) being arranged internally to the drive masses of the first and second pairs (D1,D2, D3,D4), and wherein said first roll sense mass (R1) is elastically coupled to the first and third drive masses (D1, D3), by respective elastic coupling elements (138), aligned along the first horizontal axis (X') and said second roll sense mass (R2) is elastically coupled to the second and fourth drive masses (D2, D4), by respective elastic coupling elements (138), aligned along the first horizontal axis (X');
a first pair of yaw sense masses (Y1,Y2) and a second pair of yaw sense masses (Y3, Y4), for sensing a yaw angular velocity around a vertical axis (Z') orthogonal to said horizontal plane (X'Y'), arranged externally and coupled to the drive masses of the first, respectively the second pair (D1,D2, D3,D4) by respective coupling elastic elements (139),
wherein said pitch sense masses (P1,P2), said roll sense masses (R1,R2) and said yaw sense masses (Y1,Y2, Y3,Y4) are driven by said drive masses (D1,D2, D3,D4), with a common drive mode, in order to perform the respective sense movements of the pitch, roll and yaw angular velocities, and
wherein each of the drive masses (D1, D2, D3, D4) is elastically coupled to the substrate through a respective anchoring elastic element (161, 163) that is constrained to a respective drive anchor (162, 164) integral with the substrate, the anchoring elastic element (161, 163) defining said elastic group (36) and the drive anchor (162, 164) defining said anchoring element (40).
